Europäisches Patentamt

European Patent Office

Office européen des brevets

(19)

(11) Numéro de publication : **0 332 491 B1**

(12) **FASCICULE DE BREVET EUROPEEN**

(45) Date de publication du fascicule du brevet :
**20.05.92 Bulletin 92/21**

(51) Int. Cl.⁵ : **C30B 7/00, C30B 29/58**

(21) Numéro de dépôt : **89400487.8**

(22) Date de dépôt : **22.02.89**

(54) **Système de cristallogénèse, notamment pour vaisseau spatial.**

(30) Priorité : **29.02.88 FR 8802479**

(43) Date de publication de la demande :
**13.09.89 Bulletin 89/37**

(45) Mention de la délivrance du brevet :
**20.05.92 Bulletin 92/21**

(84) Etats contractants désignés :
**DE GB IT**

(56) Documents cités :
**JOURNAL OF CRYSTAL GROWTH, vol. 76, no. 3, 11 août 1986, "Protein crystal growth", Proceedings of the first InternationalConference on Protein Crystal Growth, Stanford, Ca., 14-16 août 1985, éditeur par R.S. Feigelson, pages 663-672, Elsevier SciencePublishers B.V. (North-Holland Physics Publishing Division), Amsterdam, NL; W. LITTKE et al.: "Protein single crystal growth undermicrogravity"**

(73) Titulaire : **AEROSPATIALE SOCIETE NATIONALE INDUSTRIELLE Société Anonyme dite:**
**37, Boulevard de Montmorency**
**F-75016 Paris (FR)**

(72) Inventeur : **Martin, Gérard Michel**
**34 bis rue Charles Tauchon**
**F-59300 Valenciennes (FR)**
Inventeur : **Auffret, Jean-Claude**
**39 rue du bout Malo Chapet**
**F-78130 Les Mureaux (FR)**
Inventeur : **Claramonte, Manuel**
**24 rue du Coteau**
**F-92370 Chaville (FR)**

(74) Mandataire : **Bonnetat, Christian et al**
**CABINET BONNETAT 23, Rue de Léningrad**
**F-75008 Paris (FR)**

## Description

La présente invention concerne un système de cristallogénèse, spécialement mais non limitativement destiné à être mis en oeuvre à bord d'un vaisseau spatial.

On sait que l'une des méthodes d'étude des substances macromoléculaires consiste à former des cristaux desdites substances et à soumettre lesdits cristaux à des examens, notamment spectrographiques. Pour former de tels cristaux, on utilise des méthodes de diffusion, éventuellement à travers une paroi poreuse de diffusion. A cet effet, dans une enceinte, on dispose un creuset rempli d'un mélange liquide d'une substance macromoléculaire à étudier et d'un agent précipitant en concentration insuffisante pour agir, puis on introduit dans ladite enceinte un tel agent précipitant afin de provoquer la cristallisation en diminuant la concentration de substance (phase liquide) ou en l'augmentant (phase vapeur) ou à concentration constante (dialyse).

Par diffusion, la concentration du mélange de l'agent précipitant et de la substance macromoléculaire contenu dans le creuset tend à s'aligner sur celle de l'agent précipitant contenu dans l'enceinte. Par suite, en faisant varier la concentration de ce dernier agent précipitant, on peut agir sur la cristallisation de ladite substance macromoléculaire. Généralement, le creuset et l'enceinte sont au moins partiellement transparents, de sorte qu'un opérateur peut suivre visuellement le développement de la cristallisation.

Toutefois, les cristaux obtenus dans les laboratoires terrestres par la mise en oeuvre de ces techniques de diffusion ne sont pas parfaits, tant en qualité qu'en taille, notamment à cause des phénomènes de convexion dus à la pesanteur.

Pour remédier à cet inconvénient, il est avantageux de pouvoir mettre en oeuvre de telles techniques de diffusion à bord de vaisseaux spatiaux, car alors les conditions d'apesanteur éliminent ces phénomènes de convexion.

Cependant, les tentatives pour mettre en oeuvre telles quelles les méthodes terrestres se heurtent à des difficultés, sinon des impossibilités, dues notamment aux conditions de travail à bord des vaisseaux spatiaux et aux conditions de lancement de ceux-ci, ainsi qu'à la faible durée de vie de certaines substances macromoléculaires (une quinzaine de jours pour les protéines par exemple). Par exemple, compte tenu des impératifs et des délais de préparation relativement longs du lancement d'un vaisseau spatial, les substances macromoléculaires sont mortes avant que leur cristallisation dans l'espace puisse être tentée.

Pour remédier à ces inconvénients, la demande de brevet français n° 87 02947 (FR-A-2 511 626) déposée le 4 Mars 1987 au nom de la demanderesse décrit un système de cristallogénèse permettant d'adapter les méthodes de diffusion à une utilisation à bord d'un vaisseau spatial, bien que pouvant cependant être utilisé dans un laboratoire terrestre. Ce système de cristallogénèse par diffusion, dans lequel une substance à cristalliser contenue dans un creuset est mise en présence d'un agent précipitant, comporte :

– au moins un réceptacle en communication avec des moyens d'amenée et des moyens d'évacuation d'agent précipitant ;

– au moins une capsule étanche enfermant au moins un tel creuset et remplie d'agent précipitant, ledit creuset contenant ladite substance à cristalliser ; et

– des moyens de connexion permettant automatiquement de relier l'intérieur de ladite capsule avec lesdits moyens d'amenée et avec lesdits moyens d'évacuation d'agent précipitant lors de l'introduction de ladite capsule étanche dans ledit réceptacle.

On voit que ledit réceptacle, lesdits moyens d'amenée d'agent précipitant et lesdits moyens d'évacuation d'agent précipitant peuvent former un sous-ensemble fixe qui contient les produits sans contraintes de péremption trop importantes et qui peut être installé et mis en place dans une station spatiale, voire même dans le véhicule de transport pour la mise en orbite, plusieurs semaines avant le début des expériences de cristallisation. En revanche, la ou les capsules étanches, de préférence modulaires, sont manipulables aisément et peuvent, après avoir été préparées en laboratoire, être embarquées au dernier moment par les astronautes et, de plus, rapportées par ceux-ci après l'expérience.

Ainsi, grâce à ce système, on peut obtenir un délai minimal entre la fabrication des macromolécules à étudier et le début des expériences de cristallisation en apesanteur. De plus, ce système permet par là même de réduire les coûts du transport des vols spatiaux aussi bien à l'aller qu'au retour, coûts qui sont liés au volume et à la masse emportés à chaque fois. Grâce au fait que la capsule étanche est remplie d'agent précipitant, on évite tout risque de contamination de la substance à cristalliser avant mise en place de ladite capsule dans ledit réceptacle, c'est-à-dire avant le début de la cristallisation. Cet agent précipitant remplissant la capsule avant le début de l'expérience de cristallisation doit présenter une concentration suffisamment faible pour être inerte vis-à-vis de la substance à cristalliser, afin de ne pas déclencher un commencement de cristallisation. Toutefois, grâce à une autre particularité du système, dans certains cas où cela est nécessaire, ledit agent précipitant initialement introduit dans la capsule peut présenter une concentration qui le rendrait actif.

Dans un mode de réalisation de ce système de cristallogénèse, lesdits moyens de connexion prévus pour automatiquement relier l'intérieur de la capsule avec les moyens d'amenée et d'évacuation comportent, d'une part, des aiguilles d'amenée et d'évacuation liées audit réceptacle et, d'autre part, des blocs de matière susceptible d'être perforée de manière étanche par lesdites aiguilles, lesdits blocs étant liés à ladite capsule. De tels blocs, par exemple réalisés en un polymère présentant d'importantes propriétés d'élasticité, sont généralement connus dans les techniques médicales, pharmaceutiques ou biologiques sous le nom de septum. Grâce à de tels moyens de connexion, on voit que ladite capsule s'enfiche, par ses septums, sur les aiguilles du réceptacle. Lorsque cet enfichage est réalisé, il suffit d'agir sur les moyens d'amenée d'agent précipitant pour introduire dans ladite capsule un agent précipitant de concentration désirée, ce qui modifie la concentration de l'agent précipitant initialement présent dans la capsule et permet le déclenchement de la cristallisation. Par contrôle de la quantité et/ou de la concentration de l'agent précipitant ainsi introduit, on a la possibilité d'agir sur la cristallisation de la substance contenue dans le creuset. De plus, grâce à cet enfichage, du liquide précipitant antérieurement présent dans la capsule peut être évacué par lesdits moyens d'évacuation sous la pression du liquide précipitant introduit par lesdits moyens d'amenée. Ainsi, bien que la capsule ait un volume constant et qu'elle soit initialement pleine, on peut introduire de l'agent précipitant frais, l'agent précipitant frais introduit chassant une quantité égale d'agent précipitant de la capsule. Pour recueillir l'agent précipitant chassé de la capsule, lesdits moyens d'évacuation comportent un vase d'expansion.

L'objet de la présente invention est de perfectionner le système antérieur décrit ci-dessus, afin de simplifier et d'alléger ladite capsule, d'optimiser les volumes d'agent précipitant injectés, d'améliorer l'homogénéisation de cet agent précipitant et d'améliorer les temps d'expérience.

A ces fins, selon l'invention, le dispositif de cristallogénèse par diffusion, notamment destiné à être mis en oeuvre à bord d'un vaisseau spatial, et dans lequel une substance à cristalliser contenue dans un creuset est mise en présence d'un agent précipitant, ledit dispositif comportant :

– au moins un réceptacle en communication avec des moyens d'amenée d'agent précipitant et des moyens d'évacuation d'agent précipitant ;

– au moins une capsule étanche enfermant au moins un tel creuset et remplie d'agent précipitant, ledit creuset contenant ladite substance à cristalliser ; et

– des moyens de connexion permettant automatiquement de relier l'intérieur de ladite capsule avec lesdits moyens d'amenée et avec lesdits moyens d'évacuation d'agent précipitant, lors de l'introduction de ladite capsule étanche dans ledit réceptacle, lesdits moyens de connexion comportant, d'une part, des aiguilles d'amenée et d'évacuation liées audit réceptacle et, d'autre part, des blocs d'une matière susceptible d'être perforée de manière étanche par lesdites aiguilles, lesdits blocs étant liés à ladite capsule, est remarquable :

– en ce que la cavité intérieure de ladite capsule étanche présente une forme de révolution autour d'un axe et est constituée d'une première partie de forme au moins approximativement ogivale et d'une seconde partie de forme au moins approximativement cylindrique dans laquelle se trouve ledit creuset, lesdites première et seconde parties se raccordant de façon au moins approximativement tangentielle ;

– en ce qu'une paroi transversale poreuse sépare lesdites première et seconde parties de la cavité intérieure, au moins approximativement au niveau de leur raccord ;

– en ce que l'aiguille d'amenée desdits moyens de connexion, reliée auxdits moyens d'amenée, se trouve disposée coaxialement à ladite cavité intérieure, au sommet de la première partie ogivale, lorsque ladite capsule est reliée audit réceptacle ;

– en ce que l'extrémité de ladite aiguille d'amenée pénétrant dans ladite capsule, est obturée axialement mais est pourvue d'orifices latéraux susceptibles de se trouver en regard de la paroi de ladite première partie ogivale ;

– en ce que l'aiguille d'évacuation desdits moyens de connexion, reliée auxdits moyens d'évacuation, se trouve disposée de façon excentrée par rapport à la cavité intérieure, lorsque ladite capsule est reliée audit réceptacle ; et

– en ce que ladite capsule comporte au moins un conduit susceptible de mettre en communication ladite aiguille d'évacuation avec ladite cavité intérieure.

Ainsi, grâce à la conformation de ladite cavité intérieure et à la disposition de l'aiguille d'amenée et de ses orifices, on peut obtenir un front de diffusion particulièrement plan et homogène qui occupe toute la section transversale de la cavité de la capsule : on obtient donc des conditions particulièrement bonnes pour la réaction.

Pour améliorer encore l'écoulement de l'agent précipitant, on fait en sorte que le volume de la portion de ladite première partie ogivale de la cavité entourant ladite aiguille d'amenée soit au plus égale au plus petit volume injectable d'agent précipitant injecté dans ladite cavité.

Afin de pouvoir utiliser une quantité d'agent précipitant maximale, ledit conduit débouche soit dans ladite seconde partie cylindrique de ladite cavité intérieure au voisinage dudit creuset, lorsque le dispositif ou système est destiné à la cristallogénèse par dialyse ou par diffusion en phase liquide, soit dans ladite première partie ogivale de ladite cavité intérieure, au voisinage de ladite paroi transversale, lorsque ledit système est utilisé à la cristallogénèse par diffusion en phase vapeur.

De préférence, pour optimiser l'évacuation d'un trop-plein d'agent précipitant, ladite capsule comporte un réservoir, dans lequel débouche ledit conduit et dans lequel est susceptible de pénétrer ladite aiguille d'évacuation.

Afin de pouvoir conduire des expériences avec des agents précipitants différents et/ou avec un agent précipitant à différentes concentrations, ladite aiguille d'amenée est reliée à plusieurs sources distinctes d'agent précipitant par l'intermédiaire de clapets anti-retour. De préférence, chaque source d'agent précipitant est constituée par une seringue ou analogue. Chaque seringue sert ainsi à la fois de réservoir d'agent précipitant et de moyen d'injection de celui-ci dans la capsule. Une telle seringue peut être de tout type connu et l'actionnement de son piston peut être manuel ou bien motorisé. Quelle que soit la nature des moyens d'actionnement, il est toutefois important que ceux-ci permettent de connaître la quantité d'agent précipitant injectée. De préférence, on prévoit plusieurs seringues contenant de l'agent précipitant à des concentrations différentes. Ainsi, le contrôle de la cristallisation de la substance contenue dans le creuset en est facilité.

Avantageusement, le système selon l'invention comporte un bouchon pouvant être introduit dans ledit réceptacle à la place de ladite capsule, ledit bouchon comportant un corps spongieux imbibé d'agent précipitant et accessible auxdites aiguilles d'amenée et d'évacuation desdits moyens de connexion à travers des blocs (septums) solidaires dudit bouchon et réalisés en une matière susceptible d'être perforée de manière étanche par lesdites aiguilles. Un tel bouchon est mis en place dans le réceptacle à la place de ladite capsule avant l'enfichage de celle-ci, et éventuellement après la sortie de ladite capsule dudit réceptacle, notamment pendant les phases de transport, de sorte que les aiguilles peuvent constamment être baignées par de l'agent précipitant, ce qui leur évite tout risque de contamination et d'obstruction.

On sait que les techniques de diffusion utilisées en cristallogénèse sont variées en ce qui concerne le processus de diffusion. L'un des objets de la présente invention est de concevoir une capsule qui soit apte, sans aucune modification ou tout au moins avec un minimum de modifications, à être utilisée quel que soit le processus de diffusion mis en oeuvre (dialyse, diffusion liquide/liquide et diffusion liquide/vapeur).

Ainsi, les utilisateurs du système selon l'invention bénéficient d'une grande souplesse d'expérimentation et les coûts de matériel et d'expérience sont réduits.

A cette fin, il est avantageux qu'un obturateur commandable, manuellement ou par l'intermédiaire de moyens moteurs, soit prévu à l'intérieur de ladite capsule, afin soit d'obturer ledit creuset pour isoler son contenu de la cavité intérieure de ladite capsule, soit de dégager ledit creuset pour mettre son contenu en communication avec cette dernière cavité. Ainsi, lorsque cela est nécessaire pour certaines fins expérimentales, il est possible de remplir ladite capsule d'agent précipitant à une concentration très voisine de la concentration théorique de formation des cristaux, sans pour cela amorcer de façon prématurée la cristallogénèse, puisqu'alors l'obturateur peut isoler le creuset de la capsule. Lorsque l'expérience doit commencer, il suffit alors de faire passer ledit obturateur, directement associé au creuset, de sa position d'obturation à sa position de dégagement.

Dans un mode de réalisation avantageux, ledit obturateur commandable est un disque ajouré monté rotatif autour d'un arbre accessible de l'extérieur de ladite capsule. La rotation dudit disque peut être obtenue manuellement ou par l'action de moyens moteurs. Quel que soit le mode d'actionnement du disque, on voit que ledit creuset est obturé lorsqu'il se trouve en regard d'une partie pleine du disque et au contraire dégagé, lorsqu'il se trouve en regard d'un orifice de celui-ci.

En position d'obturation du creuset par le disque, celui-ci s'applique sur les bords de l'ouverture dudit creuset. Pour éviter que, dans son mouvement, le disque ne détériore par frottement, l'éventuelle membrane (nécessaire en diffusion par dialyse) recouvrant le creuset, il est avantageux que ledit arbre du disque rotatif puisse coulisser de façon limitée, parallèlement à son axe, de façon que ledit disque soit écarté du creuset pendant le passage du disque d'une position d'obturation à une position de dégagement et vice-versa.

Pour éliminer encore plus le risque de détérioration de l'éventuelle membrane de dialyse recouvrant le creuset, on prévoit qu'au moins la partie de l'obturateur entrant en contact avec le creuset dans une position d'obturation est constituée par une membrane souple.

Dans le cas d'une diffusion liquide/vapeur, la paroi transversale poreuse est un élément de rétention d'agent précipitant et un obturateur commandable supplémentaire est alors associé audit élément de rétention ; il peut être lié en rotation à l'obturateur commandable associé directement au creuset.

Les figures du dessin annexé feront bien comprendre comment l'invention peut être réalisée. Sur ces figures, des références identiques désignent des éléments semblables.

La figure 1 illustre, de façon simplifiée et schématique, un système selon l'invention avant, et éventuellement après, une expérience de cristallogénèse.

La figure 2 illustre, de façon semblable à celle de la figure 1, ledit système pendant une expérience de cristallogénèse.

La figure 3 montre, en coupe axiale, un mode de réalisation avantageux pour une capsule destinée à la cristallogénèse par dialyse.

La figure 4 est une coupe transversale suivant la ligne IV-IV, respectivement des figures 3 et 8.

La figure 5 est une coupe transversale suivant la ligne V-V de la figure 3.

La figure 6 est une vue partielle suivant la flèche F de la figure 3.

La figure 7 illustre une variante de réalisation des moyens d'actionnement du disque obturateur.

La figure 8 montre, en coupe axiale, un mode de réalisation avantageux pour une capsule destinée à la diffusion en phase vapeur.

La figure 9 est une coupe transversale suivant la ligne IX-IX de la figure 8.

La figure 10 est une coupe transversale partielle suivant la ligne X-X de la figure 8.

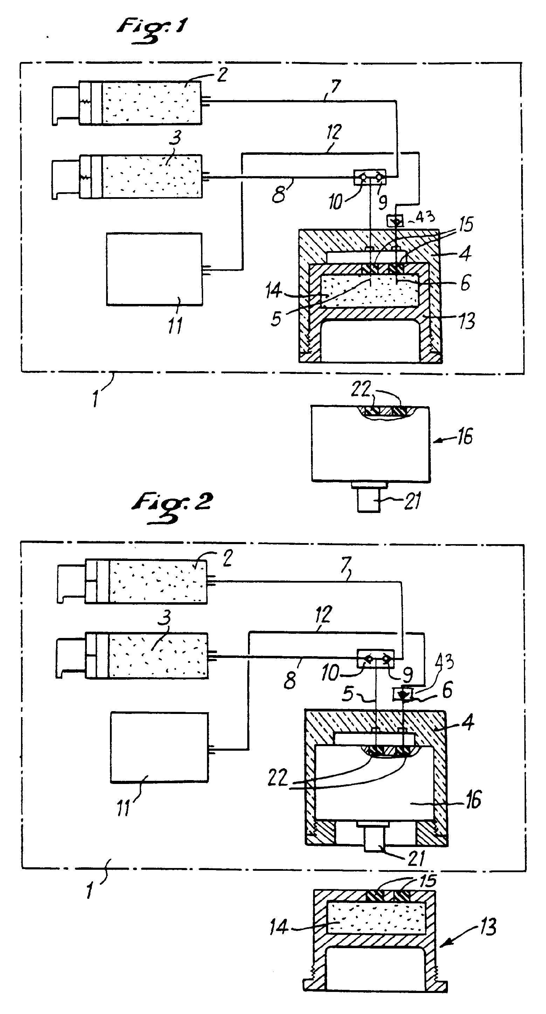

Sur les figures 1 et 2, on a indiqué schématiquement par un rectangle en trait mixte, un caisson thermostaté 1 mécaniquement solidaire, par exemple, de la structure d'une station spatiale. Ce caisson thermostaté 1 ne fait pas partie du cadre de la présente invention et peut être réalisé de toute façon connue.

A l'intérieur du caisson thermostaté 1 sont montés :
– des seringues 2 et 3 contenant un agent précipitant à des concentrations différentes ;
– un réceptacle 4, par exemple en forme de boîte ouverte et dans le fond duquel sont prévues une aiguille centrale 5, et une aiguille excentrée 6 ;
– des canalisations 7 et 8 reliant respectivement la sortie des seringues 2 et 3 à l'aiguille centrale 5, par l'intermédiaire de clapets anti-retour 9 et 10 ;
– un vase d'expansion ou de trop-plein 11 relié à l'aiguille excentrée 6 par l'intermédiaire d'une canalisation 12 ;
– un bouchon 13 pour le réceptacle 4, comportant un corps spongieux 14 qui est imbibé d'agent précipitant et dans lequel pénètrent lesdites aiguilles 5 et 6 lorsque ledit bouchon 13 est en position d'obturation dudit réceptacle. A cet effet, le fond du bouchon 13 comporte des blocs 15, en une matière pouvant être perforée de façon étanche par lesdites aiguilles 5 et 6, qui peuvent ainsi atteindre le corps spongieux 14.

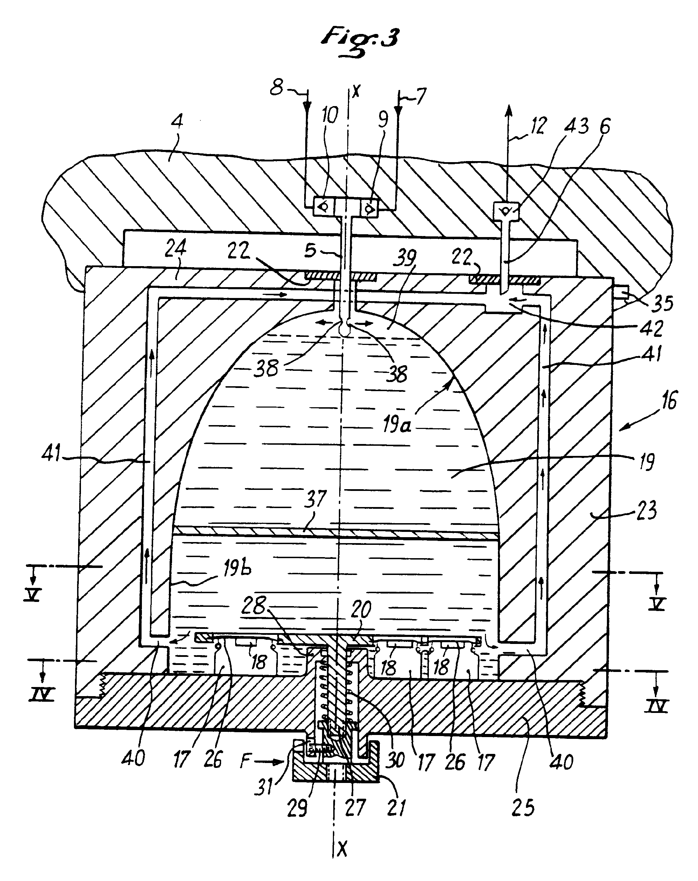

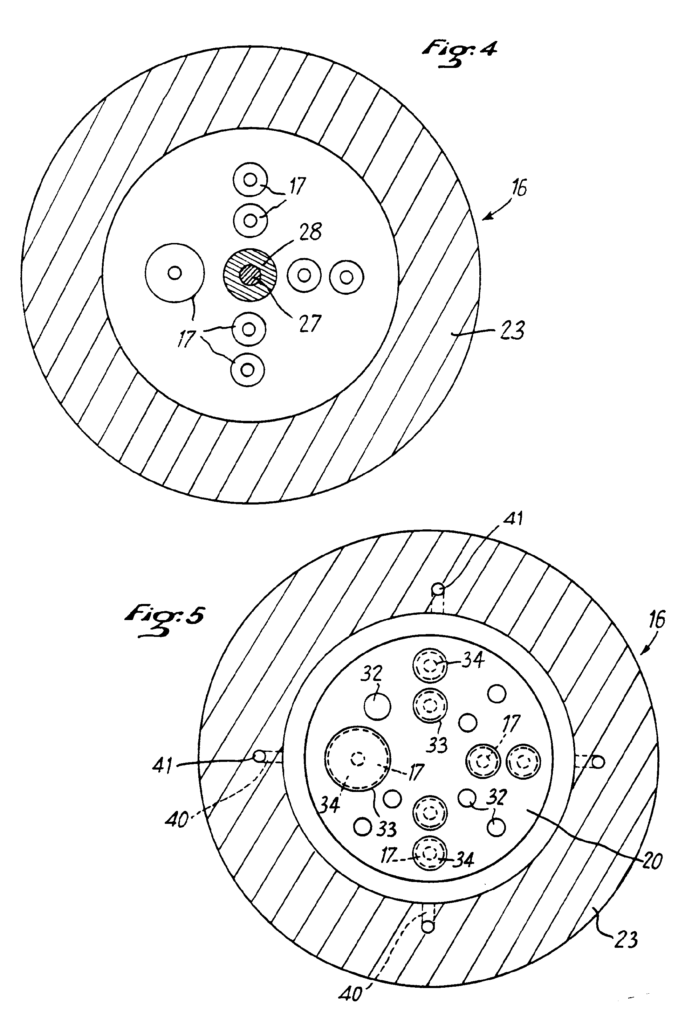

Par ailleurs, le système selon l'invention montré par les figures 1 et 2 comporte une capsule étanche 16 enfermant (voir les figures 3,4 et 5) au moins un creuset 17, dans la cavité 18 duquel peut être introduit un mélange d'une substance macromoléculaire à cristalliser et d'agent précipitant à une concentration inactive. La cavité intérieure 19 de la capsule étanche 16 est remplie d'agent précipitant. La cavité 18 du creuset 17 peut être isolée, ou au contraire mise au contact, de l'agent précipitant contenu dans la cavité 19 de la capsule 16, grâce à un obturateur mobile 20, mû par un organe d'actionnement 21. Une paroi de la capsule étanche 16 comporte des blocs 22, semblables aux blocs 15 du bouchon 13, réalisés en une matière susceptible d'être perforée de manière étanche par des aiguilles.

Les formes extérieures du bouchon 13 et de la capsule étanche 16 sont telles qu'ils sont interchangeables à l'intérieur du réceptacle 4.

Lorsque, comme cela est montré sur la figure 1, le bouchon 13 est en place à l'intérieur du réceptacle 4, la capsule 16 est physiquement indépendante de l'ensemble constitué des éléments 2 à 15. Il est donc possible de monter dans une station spatiale ledit ensemble 2 à 15, qui ne contient que des substances à durée de vie relativement longue, longtemps avant de charger, au lieu de sa fabrication, la substance macromoléculaire à cristalliser dans le creuset 17. Ainsi, tous les préparatifs des expériences de cristallisation, autres que ceux concernant la substance à cristalliser, peuvent être terminés, ou en cours d'achèvement, lorsque la capsule 16 est rapprochée physiquement de l'ensemble 2 à 15, en vue d'une expérience de cristallisation.

Lorsque les conditions de cette expérience sont réunies, on ôte le bouchon 13 du réceptacle 4 et on le remplace par la capsule 16 (voir la figure 2). Alors, les aiguilles 5 et 6 traversent les blocs 22 et débouchent donc dans la capsule 16. En agissant sur les seringues 2 et 3 (manuellement ou par l'intermédiaire d'un moteur), on injecte dans cette cavité 19 des quantités connues d'agent précipitant à des concentrations différentes de celles qui préexistaient dans la capsule 16. On modifie donc la concentration de l'agent précipitant initialement contenu dans la capsule 16 et, si l'obturateur 20 est dégagé, on agit sur la cristallisation de la substance macromoléculaire contenue dans la cavité 18 du creuset 17. L'excédent d'agent précipitant injecté dans la capsule 16 est évacué par la canalisation 12 vers le vase de trop-plein 11.

Enfin, lorsque l'expérience de cristallisation est terminée, la capsule 16 est sortie du réceptacle 4 et remplacée par le bouchon 13 (figure 1). La capsule 16 peut alors être amenée en tout lieu désiré pour l'étude des cristaux obtenus.

Sur les figures 3,4 et 5, on a représenté un mode de réalisation avantageux pour une capsule 16, plus particulièrement destinée à la cristallogénèse par dialyse. Cette capsule 16 comporte un corps 23, par exemple cylindrique, obturé par un fond 24, dans lequel sont prévus les blocs élastiques 22, et par un fond 25 portant une pluralité de creusets 17. Chacun desdits creusets 17 est obturé par une membrane de dialyse 26.

Le disque rotatif d'obturation 20 est solidaire d'un arbre 27 pouvant tourner et coulisser dans un palier 28, solidaire du fond 25. De plus, l'arbre 27 porte un ergot 29, appliqué par un ressort 30, disposé entre ledit fond 25 et ledit disque 20, contre une rampe 31 solidaire du fond 25.

Le disque d'obturation 20 est pourvu d'une pluralité d'orifices 32 ouverts et d'une pluralité d'orifices 33, obturés par une membrane souple 34. Le nombre et la disposition des orifices 32 et 33 sont tels que, pour une première position angulaire du disque 20, tous les orifices 32 se trouvent en regard des ouvertures 28 de tous les creusets 17, et que, pour une seconde position angulaire du disque 20, toutes les membranes 34 sont en appui contre les bords des cavités 18 et contre toutes les membranes de dialyse 26 de tous les creusets 17 (position représentée sur la figure 5).

Pour passer de l'une de ces positions à l'autre, il suffit de faire tourner l'arbre 27, soit manuellement (figure 3), soit à l'aide d'un moteur (figure 7). Au cours de la rotation, grâce à la coopération de l'ergot 29 et de la rampe 31 sous l'action du ressort 30, le disque 20 est soulevé, ce qui évite la détérioration par frottement des membranes de dialyse 26.

Le corps 23 de la capsule 16 comporte un ergot d'indexage 35 permettant, par coopération avec un élément complémentaire (non représenté) du réceptacle 4, d'amener les blocs élastiques 22 en regard des aiguilles 5 et 6. De plus, dans le cas où le réceptacle 4 doit recevoir une capsule spécifique 16, on peut prévoir au moins un ergot de détrompage (non représenté).

La cavité intérieure 19 de la capsule 16 présente une forme de révolution autour d'un axe X-X, qui est confondu avec celui de l'aiguille centrale 5, lorsque ladite capsule est mise en place dans le réceptacle 4. Cette cavité intérieure présente une partie supérieure 19a, de forme ogivale, et une partie inférieure 19b, de forme cylindrique, lesdites parties 19a et 19b étant centrées sur l'axe X-X et se raccordant tangentiellement. A l'intérieur de la cavité 19, au raccord des parties ogivale 19a et cylindrique 19b est prévue une grille de diffusion transversale 37, qui peut être un matériau spongieux, un filtre ou une toile.

L'aiguille centrale 5 est pourvue d'orifices de sortie latéraux 38, disposés en regard de la paroi ogivale de la partie 19a de la cavité intérieure 19. Le volume 39 délimité fictivement entre l'extrémité de l'aiguille centrale 5 et la paroi ogivale de la partie 19a est choisi de façon qu'il soit au moins égal à la plus petite quantité d'agent précipitant injectable dans la cavité 19.

Dans la partie inférieure cylindrique 19b de la cavité 19, sont prévues des prises de liquide 40, qui, par des conduits 41 par exemple ménagés dans le corps 23 de la capsule 16, sont en communication avec un réservoir 42, par exemple également ménagé dans ledit corps 23. Le réservoir 42 est obturé par le bloc élastique 22 associé à l'aiguille excentrée 6, qui peut ainsi pénétrer dans ledit réservoir 42. Un clapet anti-retour 43 peut être disposé entre la conduite 12 et l'aiguille excentrée 6.

Les clapets anti-retour 9,10 et 43 peuvent être incorporés au réceptacle 4.

On voit ainsi que, grâce à l'invention :
– il n'est prévu que deux aiguilles, à savoir une aiguille centrale d'amenée ou d'injection 5 et une aiguille d'évacuation ou de trop-plein 6, même lorsqu'on désire injecter plusieurs agents précipitants différents et/ou de concentration différentes ; le système de l'invention est donc simple.
– la disposition radiale des orifices 38 de l'aiguille d'amenée 5 en regard de la paroi de la partie ogivale 19a de la cavité 19 permet aux jets d'agent précipitant injecté de se briser contre cette paroi, de sorte que l'on obtient directement, sans nécessité d'un élément supplémentaire telle qu'une paroi transversale spécifique, une bonne homogénéisation de l'agent précipitant injecté. De plus, grâce à cette disposition, l'agent précipitant est rapidement au niveau des creusets 17, de sorte que le temps d'expérience est optimisé ;
– la forme ogivale de la paroi 19a, associée à l'injection radiale de l'agent précipitant permet de plus d'obtenir un large front de diffusion plan, favorisant les réactions ainsi que d'assurer l'écoulement progressif et irrémédiable de l'agent précipitant ; et
– la disposition inférieure des prises de trop-plein 40 permet d'utiliser des quantités importantes d'agent précipitant, sans risque d'évacuation prématurée de celui-ci.

Si au lieu de mettre en oeuvre un processus de dialyse, on désire procéder à une diffusion en phase liquide/liquide, on peut utiliser le mode de réalisation des figures 3 à 7 en supprimant les membranes de diffusion 26 obturant les creusets 17.

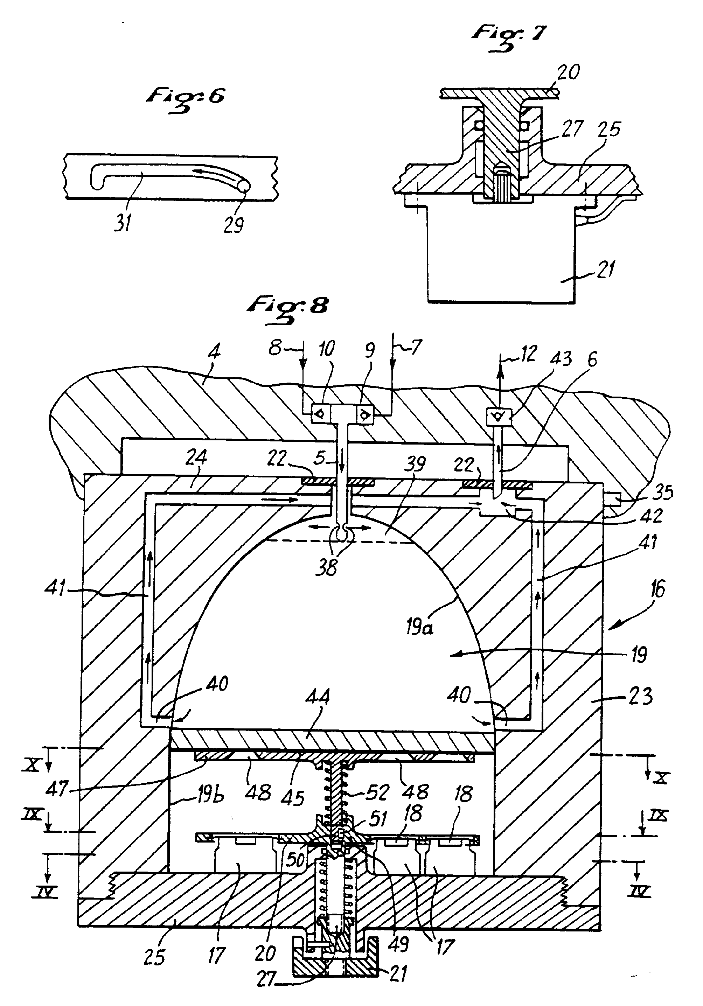

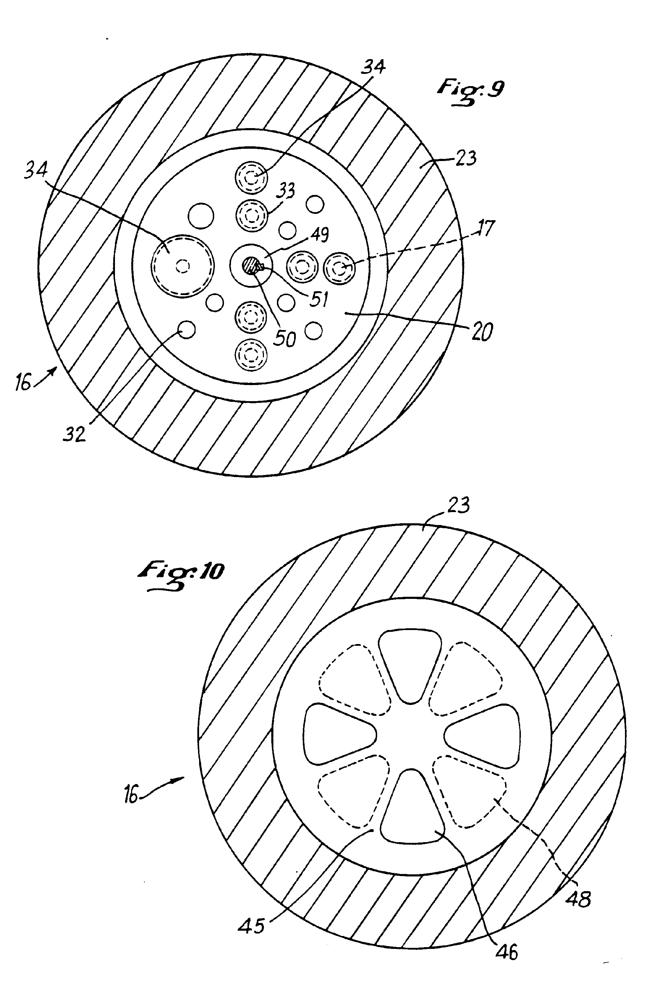

Le mode de réalisation de la capsule 16 selon l'invention, représenté sur les figures 8,9 et 10, est plus spécialement destiné à la mise en oeuvre de cristallogénèse par diffusion liquide/vapeur. Pour l'essentiel, ce mode de réalisation est semblable à celui illustré sur la figure 3 pour une diffusion liquide/liquide. Toutefois, dans ce cas, la chambre 19b agencée au-dessus du disque obturateur 20 est remplie d'un gaz. Aussi, dans le mode de réalisation des figures 8 à 10, la grille de diffusion 37 de la figure 3 est remplacée par un élément de rétention 44 pour l'agent précipitant liquide. Cet élément de rétention 44 est par exemple un corps spongieux.

De plus, pour commander le remplissage de la chambre 19b en vapeur d'agent précipitant, on prévoit un système obturateur supplémentaire (voir également la figure 10). Ce système obturateur supplémentaire comporte par exemple une plaque fixe transversale 45, pourvue d'ouvertures 46 et supportant l'élément de rétention 44, ainsi qu'un disque rotatif 47 percé d'ouvertures 48. Le disque rotatif 47 est appliqué contre la plaque fixe transversale 45, du côté opposé à l'élément de rétention 44, et, par rotation dudit disque 47, les ouvertures 48 de celui-ci peuvent être amenées, soit en coïncidence avec les ouvertures 46 de la plaque 45, soit dans une position pour laquelle lesdites ouvertures 46 sont obturées par la partie non ajourée du disque 47 (position d'obturation représentée sur la figure 10).

De préférence, la commande en rotation du disque d'obturation 47 est couplée avec celle du disque obturateur 20. Pour ce faire, le disque 20 peut comporter un logement 49 pour l'arbre 50 du disque 47, ledit arbre 50 étant lié en rotation au disque obturateur 20 par une clavette 51. Un ressort 52 peut être prévu, d'une part, pour plaquer élastiquement le disque rotatif 47 contre la plaque fixe 45 et, d'autre part, pour désaccoupler les disques 20 et 47, lors du mouvement d'écartement et le rapprochement du disque 20 par rapport aux creusets 17.

Les figures 3 à 10 montrent que, quel que soit le processus de diffusion mis en oeuvre, les capsules utilisées présentent des structures semblables.

## Revendications

1. Dispositif de cristallogénèse par diffusion, notamment destiné à être mis en oeuvre à bord d'un vaisseau spatial, et dans lequel une substance à cristalliser contenue dans un creuset (17) est mise en présence d'un agent précipitant, ledit système comportant :
   - au moins un réceptacle (4) en communication avec des moyens d'amenée d'agent précipitant (2,3,7,8,9,10) et des moyens d'évacuation d'agent précipitant (11,12) ;
   - au moins une capsule étanche (16) enfermant au moins un tel creuset (17) et remplie d'agent précipitant, ledit creuset contenant ladite substance à cristalliser ; et
   - des moyens de connexion (5,6,22) permettant automatiquement de relier l'intérieur de ladite capsule (16) avec lesdits moyens d'amenée (2,3,7,8,9,10) et avec lesdits moyens d'évacuation (11,12) d'agent précipitant, lors de l'introduction de ladite capsule étanche (16) dans ledit réceptacle, lesdits moyens de connexion (5,6,22) comportant, d'une part, des aiguilles d'amenée et d'évacuation (5,6) liées audit réceptacle (4) et, d'autre part, des blocs (22) d'une matière susceptible d'être perforée de manière étanche par lesdites aiguilles, lesdits blocs étant liés à ladite capsule (16),
   caractérisé :
   - en ce que la cavité intérieure (19) de ladite capsule étanche (16) présente une forme de révolution autour d'un axe (X-X) et est constituée d'une première partie (19a) de forme au moins approximativement ogivale et d'une seconde partie (19b) de forme au moins approximativement cylindrique dans laquelle se trouve ledit creuset (17), lesdites première et seconde parties se raccordant de façon au moins approximativement tangentielle ;
   - en ce qu'une paroi transversale poreuse (37,44) sépare lesdites première et seconde parties de la cavité intérieure (19), au moins approximativement au niveau de leur raccord ;
   - en ce que l'aiguille d'amenée (5) desdits moyens de connexion, reliée auxdits moyens d'amenée (2,3,7,8,9,10), se trouve disposée coaxialement à ladite cavité intérieure (19), au sommet de la première partie ogivale (19a), lorsque ladite capsule (16) est reliée audit réceptacle (4) ;
   - en ce que l'extrémité de ladite aiguille d'amenée (5), pénétrant dans ladite capsule, est obturée axialement mais est pourvue d'orifices latéraux susceptibles de se trouver en regard de la paroi de ladite première partie ogivale (19a) ;
   - en ce que l'aiguille d'évacuation (6) desdits moyens de connexion, reliée auxdits moyens d'évacuation (11,12), se trouve disposée de façon excentrée par rapport à la cavité intérieure (19), lorsque ladite capsule (16) est reliée audit réceptacle (4) ; et
   - en ce que ladite capsule (16) comporte au moins un conduit (41) susceptible de mettre en communication ladite aiguille d'évacuation (6) avec ladite cavité intérieure (19).

2. Dispositif de cristallogénèse selon la revendication 1, caractérisé en ce que le volume de la portion de ladite première partie ogivale (19a) de la cavité (19) entourant ladite aiguille d'amenée (5) est au plus égal au volume d'agent précipitant injecté dans ladite cavité (19).

3. Dispositif selon la revendication 1 ou la revendication 2, destiné à la cristallogénèse par dialyse ou par diffusion en phase liquide,
caractérisé en ce que ladite paroi poreuse est une paroi de diffusion (37) et en ce que ledit conduit (41) débouche (en 40) dans ladite seconde partie cylindrique (19b) de ladite cavité intérieure (19) au voisinage dudit creuset.

4. Dispositif selon la revendication 1 ou la revendication 2, destiné à la cristallogénèse par diffusion en phase vapeur,
caractérisé en ce que ladite paroi poreuse est une paroi de rétention (44) et en ce que ledit conduit (41) débouche (en 40) dans ladite première partie ogivale (19a) de ladite cavité intérieure (19), au voisinage de ladite paroi transversale de rétention (44).

5. Dispositif de cristallogénèse selon l'une quelconque des revendications 1 à 4,
caractérisé en ce que ladite capsule (16) comporte en réservoir (42), dans lequel débouche ledit conduit (41) et dans lequel est susceptible de pénétrer ladite aiguille d'évacuation (6).

6. Dispositif de cristallogénèse selon l'une quelconque des revendications 1 à 5,

caractérisé en ce que ladite aiguille d'amenée (5) est reliée à plusieurs sources distinctes (2,3) d'agent précipitant par l'intermédiaire de clapets anti-retour (9,10).

7. Dispositif de cristallogénèse selon la revendication 6,
caractérisé en ce que chaque source d'agent précipitant (2,3) est constituée par une seringue ou analogue.

8. Dispositif de cristallogénèse selon l'une quelconque des revendications 1 à 7,
caractérisé en ce qu'il comporte un bouchon (13) pouvant être introduit dans ledit réceptacle (4) à la place de ladite capsule (16), ledit bouchon (13) comportant un corps spongieux (14) imbibé d'agent précipitant et accessible auxdites aiguilles d'amenée et d'évacuation (5,6) desdits moyens de connexion à travers des blocs (22) solidaires dudit bouchon et réalisés en une matière susceptible d'être perforée de manière étanche par lesdites aiguilles.

9. Dispositif de cristallogénèse selon l'une quelconque des revendications 1 à 8,
caractérisé en ce qu'un premier obturateur commandable (20) est prévu à l'intérieur de ladite capsule (16), afin soit d'obturer ledit creuset pour isoler son contenu de la cavité intérieure de ladite capsule, soit de dégager ledit creuset pour mettre son contenu en communication avec cette dernière cavité.

10. Dispositif de cristallogénèse selon la revendication 9,
caractérisé en ce que ledit premier obturateur commandable (20) est un disque ajouré monté rotatif autour d'un arbre (27) accessible de l'extérieur de ladite capsule, en ce que l'arbre (27) dudit disque rotatif (20) peut coulisser de façon limitée, parallèlement à son axe, de façon que ledit disque soit écarté du creuset pendant le passage du disque d'une position d'obturation à une position de dégagement et vice-versa, et en ce que au moins la partie du premier obturateur (20) entrant en contact avec le creuset dans une position d'obturation est constituée par une embase souple (34).

11. Dispositif de cristallogénèse selon l'une des revendications 4 à 10,
caractérisé en ce qu'un second obturateur commandable (45,48) est associé à ladite paroi de rétention (44).

12. Dispositif de cristallogénèse selon la revendication 11,
caractérisé en ce que lesdits premier et second obturateurs commandables sont couplés en rotation.

**Patentansprüche**

1. Vorrichtung zur Kristallzüchtung durch Diffusion, insbesondere für Raumschiffe, bei der eine zu kristallisierende Substanz in einem Tiegel (17) mit einem Fällungsmittel zusammengebracht wird, bestehend aus:
– zumindest einem Behälter (4), der mit der Zuführeinrichtung (2, 3, 7, 8, 9, 10) des Fällungsmittels sowie mit der Ausleiteinrichtung (11, 12) des Fällungsmittels in Verbindung steht,
– zumindest einer dichten Kapsel (16), die zumindest den die zu kristallisierende Substanz enthaltenden Tiegel (17) umschließt und mit dem Fällungsmittel gefüllt ist,
– Anschlußmittel (5, 6, 22), durch die das Innere der Kapsel (16) mit der Zuführungseinrichtung (2, 3, 7, 8, 9, 10) sowie mit der Ausleitungseinrichtung (11, 12) bei Einführen der dichten Kapsel (16) in den Behälter selbsttätig verbunden werden kann und die einerseits mit dem Behälter verbundene (Punktions-) Nadeln für die Zuführung und Ausleitung (5 bzw. 6) und andererseits Blocks (22) aufweisen, die aus einem Werkstoff gefertigt sind, der auf abdichtende Weise von den Nadeln durchstoßen werden kann, und die mit den Kapseln (16) verbunden sind, dadurch **gekennzeichnet**,
– daß der Innenhohlraum (19) der dichten Kapsel (16) eine Umlauf- oder Umdrehungsform um die Achse (X-X) darstellt und aus einem ersten Teil (19a) von zumindest annähernder Spitzbogenform und einen zweiten Teil (19b) von zumindest annähernder Zylinderform gebildet ist, in dem sich der Tiegel (17) befindet, wobei der erste und der zweite Teil zumindest annähernd tangential miteinander verbunden sind,
– daß der erste und der zweite Teil des Innenhohlraums (19) zumindest annähernd in Höhe ihrer Verbindung durch eine poröse Querwand (37, 44) getrennt sind,
– daß die Zuführungsnadel (5) der Verbindungsmittel, die an den zuführenden Verbindungsmitteln (2, 3, 7, 8, 9, 10) liegt, zum Innenhohlraum (19) koaxial an der Spitze des ersten Spitzbogenteils (19a) angeordnet ist, wenn die Kapsel (16) mit dem Behälter (4) verbunden ist,
– daß das Ende der in die Kapsel eindringenden Zuführungsnadel (5) axial verschlossen und dabei jedoch mit seitlichen Öffnungen derart versehen ist, daß diese sich der Wand des ersten Spitzbogenteils gegenüberliegend befinden,
– daß die Ausleitungsnadel (6) der Verbindungsmittel, die an den ausleitenden Verbindungsmitteln (11, 12) liegt, gegenüber dem Innenhohlraum (19) exzentrisch angeordnet ist, wenn die Kapsel (16) mit dem Behälter (4) verbunden ist, und
– daß die Kapsel (16) zumindest eine Leitung (41) aufweist, mit der die Ausleitungsnadel (6) mit dem Innenhohlraum (19) in Verbindung gesetzt werden kann.

2. Vorrichtung nach Anspruch 1,
dadurch **gekennzeichnet**, daß das Volumen des Abschnitts des ersten Spitzbogenteils (19a) des die Zuführungsnadel umgebenden Hohlraums (19) höchstens das gleiche Volumen des in den Hohlraum (19) eingespritzten Fällungsmittels hat.

3. Vorrichtung nach einem der vorhergehenden Ansprüche 1 oder 2 zum Kristallzüchten durch Dialyse oder Diffusion in der Flüssigphase,
dadurch **gekennzeichnet**, daß die poröse Wand eine Diffusionswand (37) ist und daß die Leitung (41) (bei 40) in den zweiten Zylinderteil (19b) des Innenhohlraums (19) in der Nähe des Tiegels mündet.

4. Vorrichtung nach einem der vorhergehenden Ansprüche 1 oder 2 zum Kristallzüchten durch Diffusion in der Dampfphase,
dadurch **gekennzeichnet**, daß die poröse Wand eine abhaltende Wand (44) ist und daß die Leitung (41) (bei 40) in den ersten Spitzbogenteil (19a) des Innenhohlraums (19) in der Nähe der abhaltenden Wand (44) mündet.

5. Vorrichtung nach einem der vorhergehenden Ansprüche 1 bis 4,
dadurch **gekennzeichnet**, daß die Kapsel (16) eine Sammelstelle (42) aufweist, in die die Leitung (41) mündet und in die die Ausleitungsnadel (6) eindringen kann.

6. Vorrichtung nach einem der vorhergehenden Ansprüche 1 bis 5,
dadurch **gekennzeichnet**, daß Zuführungsnadel (5) über Rückschlagventile (9, 10) an mehreren verschiedenen Fällungsmittelquellen (2, 3) liegt.

7. Vorrichtung nach Anspruch 6,
dadurch **gekennzeichnet**, daß jede Fällungsmittelquelle (2, 3) als Spritze oder dgl. ausgebildet ist.

8. Vorrichtung nach einem der vorhergehenden Ansprüche 1 bis 7,
dadurch **gekennzeichnet**, daß sie einen Stopfen (13) aufweist, der an der Stelle der Kapsel (16) in den Behälter (4) eingeführt werden kann und der einen mit dem Fällungsmittel getränkten Schwammkörper (14) besitzt, der der Zuführungs- und der Ausleitungsnadel (5, 8) der Verbindungsmittel über die Blocks (22) zugänglich ist, die mit dem Stopfen verbunden und aus einem Werkstoff gefertigt sind, der auf abdichtende Weise von den Nadeln durchstoßen werden kann.

9. Vorrichtung nach einem der vorhergehenden Ansprüche 1 bis 8,
dadurch **gekennzeichnet**, daß eine steuerbare Verschlußeinrichtung (20) im Innern der Kapsel (16) vorgesehen ist, so daß der Tiegel entweder abgedichtet, um seinen Inhalt von dem Innenhohlraums zu isolieren, oder freigegeben wird, um seinen Inhalt mit diesem Hohlraum in Verbindung zu setzen.

10. Vorrichtung nach Anspruch 9,
dadurch **gekennzeichnet**, daß die erste steuerbare Verschlußeinrichtung (20) eine durchbrochene Scheibe ist, die um eine von außerhalb der Kapsel zugängliche Welle (27) drehbar eingesetzt ist, daß die Welle (27) der drehbaren Scheibe (20) eine begrenzte Gleitbewegung parallel zu ihrer Achse durchführen kann, so daß die Scheibe während des Durchgangs der Scheibe aus einer Verschließstellung in eine Freigabestellung und umgekehrt vom Tiegel abgerückt wird, und daß zumindest der Teil der ersten Verschlußeinrichtung (20), der mit dem Tiegel in Verschließstellung in Kontakt tritt, aus einem nachgiebigen Sitz oder Sockel (34) gebildet ist.

11. Vorrichtung nach einem der vorhergehenden Ansprüche 4 bis 10,
dadurch **gekennzeichnet**, daß eine zweite steuerbare Verschlußeinrichtung (45, 48) der abhaltenden Wand (44) zugeordnet ist.

12. Vorrichtung nach Anspruch 11,
dadurch **gekennzeichnet**, daß die erste und die zweite steuerbare Verschlußeinrichtung umdrehungsgekoppelt sind.

**Claims**

1. Device for crystal growth by diffusion, particularly intended to be carried out aboard a space vessel and wherein a substance to be crystallized contained in a crucible (17) is brought into presence with a precipitating agent, said system comprising :
   – at least one receptacle (4) in communication with means (2,3,7,8,9,10) for feeding said precipitating agent and means (11,12) for draining said precipitating agent ;
   – at least one tight capsule (16) enclosing at least one such crucible (17) and filled with precipitating agent, said crucible containing said substance to be crystallized ; and
   – connecting means (5,6,22) allowing automatic connection of the interior of said capsule (16) with said feeding means (2,3,7,8,9,10) and said draining means (11,12) upon insertion of said tight capsule (16) into said receptacle, said connecting means (5,6,22) comprising, on the one hand, feeding and draining needles (5,6) connected to said receptacle (4) and, on the other hand, blocks (22) of a material capable of being perforated in a tight manner by said needles, said blocks being connected to said capsule (16),
   characterized :
   – in that the internal cavity (19) of said tight capsule (16) has a revolution shape about an axis (X-X) and consists of a first portion (19a) having at least approximately an ogival shape and of a second portion (19b) having at least approximately a cylindrical shape in which said crucible (17) is disposed, said first and second portions joining each other at least approximately tangentially ;
   – in that a porous transversal wall (37,44) divides said first and second portions of the internal cavity (19) at least approximately at the level of their junction ;
– in that the feeding needle (5) of said connecting means, connected to said feeding means (2,3,7,8,9,10) is disposed coaxially to said internal cavity (19) at the apex of said first ogival portion (19a), when said capsule (16) is connected to said receptacle (4) ;
– in that the end of said feeding needle (5), penetrating into said capsule, is axially obturated but is provided with lateral apertures capable of facing the wall of said first ogival portion (19a) ;
– in that the draining needle (6) of said connecting means, connected to said draining means (11,12) is disposed eccentrically with respect to the internal cavity (19) when said capsule (16) is connected to said receptacle (4) ; and
– in that said capsule (16) comprises at least a duct (41) capable of connecting said draining needle (6) with said internal cavity (19).

2. Device for crystal growth according to claim 1, characterized in that the volume of the part of said first ogival portion (19a) of the cavity (19) surrounding said feeding needle (5) is at most equal to the volume of precipitating agent injected into said cavity (19).

3. Device according to claim 1 or claim 2, intended for crystal growth by dialysis or by diffusion in liquid phase,
characterized in that said porous wall is a diffusion wall (37) and in that said duct (41) opens (at 40) into said second cylindrical portion (19b) of said internal cavity (19), in the vicinity of said crucible.

4. Device according to claim 1 or claim 2, intended for crystal growth by diffusion in vapor phase,
characterized in that said porous wall is a retention wall (44) and in that said duct (41) opens (at 40) into said first ogival portion (19a) of said internal cavity (19), in the vicinity of said transversal retention wall (44).

5. Device for crystal growth according to any one of claims 1 to 4,
characterized in that said capsule (16) comprises a tank (42), into which opens said duct (41) and into which said draining needle (6) is capable of penetrating.

6. Device for crystal growth according to any one of claims 1 to 5,
characterized in that said feeding needle (5) is connected to several distinct sources (2,3) of precipitating agent by means of check valves (9,10).

7. Device for crystal growth according to claim 6, characterized in that each source of precipitating agent (2,3) consists of a syringe or the like.

8. Device for crystal growth according to any one of claims 1 to 7,
characterized in that it comprises a plug (13) which can be inserted into said receptacle (4) instead of said capsule (16), said plug (13) comprising a spongy body (14) soaked with precipitating agent and accessible to said feeding and draining needles (5,6) of said connecting means through blocks (22) solid with said plug and made of a material capable of being perforated in a tight manner by said needles.

9. Device for crystal growth according to any one of claims 1 to 8,
characterized in that a first controllable obturator (20) is provided inside said capsule (16) in order either to obturate said crucible for isolating its contents from the internal cavity of said capsule, or to clear said crucible so as to connect its contents with the latter cavity.

10. Device for crystal growth according to claim 9,
characterized in that said first controllable obturator (20) is a perforated disc rotatably mounted about a shaft (27) accessible from the exterior of said capsule, in that the shaft (27) of said rotary disc (20) can slide in a limited way, parallel to its axis, in order to move apart said disc from the crucible when the disc is shifted from an obturating position to a clearing position and vice versa, and in that at least the portion of the first obturator (20) coming into contact with the crucible in an obturating position consists of a flexible base (34).

11. Device for crystal growth according to one of claims 4 to 10,
characterized in that a second controllable obturator (45,48) is associated with said retention wall (44).

12. Device for crystal growth according to claim 11,
characterized in that said first and second controllable obturators are rotatably coupled.

Fig. 1

Fig. 2

Fig. 3

Fig. 4

Fig. 5

Fig: 6

Fig: 7

Fig: 8

Fig.9

Fig.10